# EUROPÄISCHE PATENTANMELDUNG

(11) **EP 1 643 646 A1**
(43) Veröffentlichungstag der Anmeldung: **05.04.2006**
(21) Anmeldenummer: 05027272.3
(22) Anmeldetag: 16.08.2003
(51) Int. Cl.: H03K 17/0812, H03K 17/687, H03K 17/785

(54) **Verfahren zur Fehlererkennung in der Datenübertragung zu einer Treiberschaltung**

(30) Priorität: 07.09.2002 DE 10241564
(62) Teilanmeldung aus: 03018528.4
(71) Anmelder: SEMIKRON Elektronik GmbH & Co. KG, 90431 Nürnberg (DE)
(72) Erfinder: Masannek, Jürgen, 90461 Nürnberg (DE)

(57) **Zusammenfassung**

Es wird Verfahren zur Fehlererkennung in der Datenübertragung von einem Kontrollrechner zu einer Treiberschaltung für Leistungshalbleiterschalter in Halbbrückenanordnung vorgestellt. Hierbei wird für jeden Leistungshalbleiterschalter (TOP, BOT) ein getrenntes Ansteuersignal von einem Kontrollrechner zur Treiberschaltung übertragen und aus jedem Ansteuersignal ein Enable-Signal für den jeweils anderen Schalter derart erzeugt, dass bei Beendigung des Ansteuersignals des Schalters das Enable-Signal des jeweils anderen Schalters gesetzt wird. Der jeweilige Leistungshalbleiterschalter wird nur dann durch die Treiberschaltung angesteuert, falls das entsprechende Ansteuersignal an der Treiberschaltung anliegt und das jeweils zugehörige Enable-Signal ebenfalls vorliegt.

## Beschreibung

### Beschreibung

Die Erfindung beschreibt ein Verfahren zur Erkennung und anschließender Behandlung eines Fehlers in der Datenübertragung der Ansteuersignale eines Kontrollrechners zu einer Treiberschaltung für Leistungshalbleiterschalter, wobei diese Leistungshalbleiterschalter in einer Halbbrückenschaltung oder einer daraus aufgebauten Schaltung, wie beispielhaft einer 3-Phasen Vollbrücke in einem Wechselrichter, angeordnet sind.

Derartige Leistungshalbleiterschalter sind nach dem Stand der Technik IGBTs (insulated gate bipolar transistor) oder MOS-FETs (Metalloxid-Feldeffekttransistor) und vorteilhafterweise in Leistungshalbleitermodulen, wie sie beispielhaft aus der DE 195 22 173 A1 bekannt sind, angeordnet. Derartige Leistungshalbleitermodule werden ebenfalls nach dem Stand der Technik, wie er beispielhaft aus U. Nicolai et al., "Applikationshandbuch IGBT- und MOSFET- Leistungsmodule", ISBN 3-932633-24-5, Seite 176 bis 196 bekannt ist, durch eine sog. Treiberschaltung angesteuert. Diese Treiberschaltung erhält von einem Kontrollrechner hierzu die Steuersignale, mit jeweils einer Leitung pro Leistungshalbleiterschalter. Die Treiberschaltung wandelt die Steuersignale auf den zur Ansteuerung der Leistungshalbleiterschalter benötigten Pegel.

Vorzugsweise bei Leistungshalbleitermodulen sowie deren Treibern, bzw. in Anwendungen dieser, wie beispielsweise der Betrieb von Drehstromgeneratoren oder - motoren, mit höheren Leistungen, größer 100kW, sind der Kontrollrechner von dem Leistungshalbleitermodul mit dem direkt benachbarten Treiber einen bis mehrerer zehn Meter voneinander getrennt angeordnet, um Störungen des Kontrollrechners durch das Leistungshalbleitermodul bzw. die Anwendung zu vermeiden. Bei Leitungslängen von mehreren Metern können verschiedenartige Störungen in dem übertragenen Ansteuersignal auftreten.

Aus der DE 195 18 860 A1 ist eine Schaltungsanordnung zur Ansteuerung zweier Schalter in Halbbrückenanordnung bekannt, wobei ein pulsweitenmoduliertes Eingangssignal den jeweiligen Treiber eines TOP- und eines BOT- Schalters ansteuert. Die jeweiligen Treiber erzeugen hieraus ein Signal für die jeweiligen Schalter. Dieses Signal wird auch dem jeweils anderen Schalter zugeführt, der es logisch mit dem Eingangssignal verknüpft und somit wird eine Verriegelung der beiden Schalter gegeneinander realisiert.

Die vorliegende Erfindung hat die Aufgabe, ein Verfahren sowohl zur Erkennung von Störungen in der Datenübertragung der Ansteuersignale eines Kontrollrechners zu einer Treiberschaltung für Leistungshalbleiterschalter, sowie zum anschließenden Schutz der Leistungshalbleiterschalter vor diesen Störungen vorzustellen.

Die Aufgabe wird gelöst durch die Maßnahmen des Anspruchs 1. Eine vorteilhafte Ausgestaltung ist im abhängigen Anspruch genannt.

Der Grundgedanke der Erfindung liegt darin für jeden Leistungshalbleiterschalter in der Treiberschaltung ein zusätzliches Enable-Signal zu erzeugen und den Leistungshalbleiterschalter nur bei Vorhandensein dieses Enable-Signal anzuschalten.

Die genannte Maßnahme basiert auf der Erzeugung eines Enable-Signals (Erlaubnis-Signal) für jeden Leistungshalbleiterschalter. Dieses Enable-Signal wird gesetzt durch das Ausschalten des komplementären Leistungshalbleiterschalters. Wenn der erste Leistungshalbleiterschalter einer Halbbrücke ausgeschaltet wird, wird dadurch das Enable-Signal des zweiten Leistungshalbleiterschalters gesetzt. Soll nun der zweite Leistungshalbleiterschalter eingeschalten werden, ist dies nur möglich, wenn ein entsprechendes Ansteuersignal anliegt und gleichzeitig das Enable-Signal vorliegt. Analoges gilt für das Enable-Signal des zweiten Leistungshalbleiterschalters.

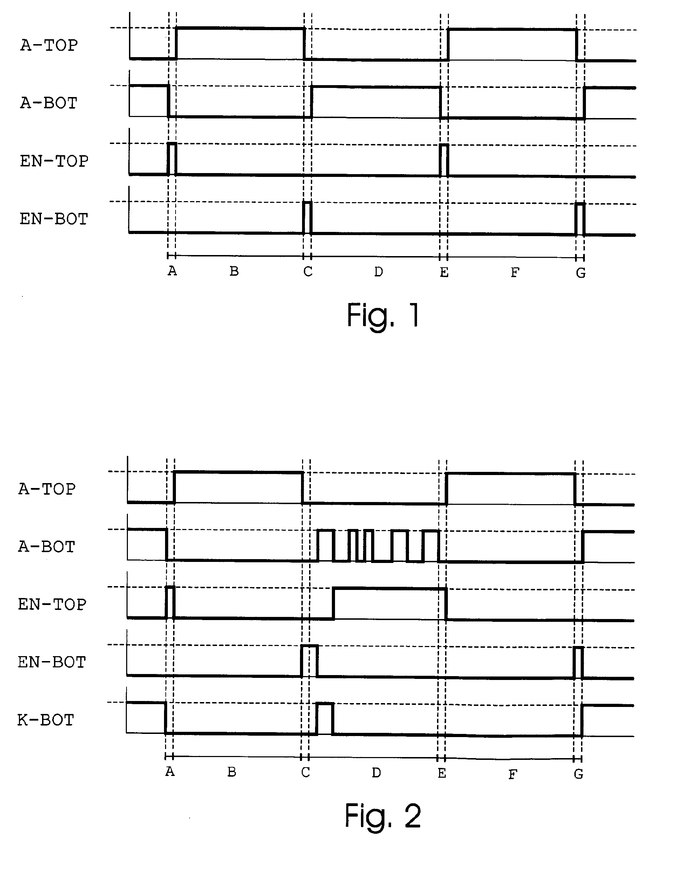

Spezielle Ausgestaltungen der erfinderischen Lösungen werden an Hand der Fig. 1 und 2 erläutert.

Fig. 1 zeigt die Ansteuersignale sowie die daraus erzeugten Enable-Signale im fehlerfreien Betrieb.

Fig. 2 zeigt die Ansteuersignale sowie die daraus erzeugten Enable-Signale im fehlerbehafteten Betrieb.

Alle nachfolgenden Figuren beziehen sich auf den folgenden beispielhaften Anwendungsfall. Der Kontrollrechner befindet sich mehrere zehn Meter entfernt von dem Leistungshalbleitermodul mit dazugehöriger Treiberschaltung. Das Leistungshalbleitermodul besteht aus 3 Halbbrücken, jede Halbbrücke besteht ihrerseits aus jeweils einem ersten Schalter (TOP-Schalter) und einem zweiten Schalter (BOT-Schalter), und steuert einen Drehstromgenerator an. Zur Vereinfachung wird im Folgenden das erfinderische Verfahren nur anhand einer Halbbrücke beschreiben, die Verallgemeinerung auf alle 3 Halbbrücken ist offensichtlich. Der Kontrollrechner und die Treiberschaltung sind mittels Lichtwellenleitern miteinander verbunden.

Soll ein Leistungshalbleiterschalter eingeschaltet sein sendet der Kontrollrechner für diesen Zeitabschnitt ein Signal auf der entsprechenden Signalleitung. Aus technischen Gründen, beispielhaft der Vermeidung von Kurzschlüssen in der Halbbrücke, ist eine Totzeit erforderlich, ein Zeitraum in dem keiner der beiden Leistungshalbleiterschalter der Halbbrücke eingeschaltet sein darf. Diese Totzeit ist abzuwarten, bevor nach dem Ausschalten eines Leistungshalbleiterschalters der jeweils komplementäre eingeschaltet werden darf. Weiterhin dürfen im Regelfall beide Leistungshalbleiterschalter nur alternierend angeschalten werden. Aufgrund von Störungen, beispielhaft durch mangelhafte Befestigung der Lichtwellenleiter am Empfänger der Treiberschaltung, treten in der Treiberschaltung verschiedenartige Störungen in den übertragenen Ansteuersignalen auf.

Fig. 1 zeigt die Ansteuersignale nach dem Stand der Technik sowie die daraus erzeugten erfindungsgemäßen Enable-Signale im fehlerfreien Betrieb. Die erste Kurve (A-TOP) zeigt das vom Kontrollrechner zur Treiberschaltung übertragenen Ansteuersignal. Hierbei entspricht ein Pegel von "high", dass die Treiberschaltung den TOP-Schalter einschalten soll. Dies geschieht nach dem Stand der Technik indem der Pegel am Ausgang des Empfängers des Lichtwellenleiters durch die Treiberschaltung auf das Potential des Leistungshalbleiterschalters umgesetzt und verstärkt und dieses Signal an den Steuereingang des Leistungshalbleiterschalters angelegt wird. Ein Pegel von "low" entspricht einen auszuschaltenden Leistungshalbleiterschalter.

Am Ende des Zeitraums (A) soll der TOP-Schalter eingeschaltet werden. Die Einschaltdauer ist der Zeitraum (B). Die abfallende Flanke des Ansteuersignals (A-TOP) des TOP-Schalters setzt das Enable-Signale (EN-BOT) des BOT-Schalters. Nach der Totzeit (C), während der kein Leistungshalbleiterschalter eingeschaltet sein darf, wird vom Kontrollrechner das Ansteuersignal (A-BOT) für den BOT-Schalter angelegt. Der BOT-Schalter wird, da sowohl das Ansteuersignal (A-BOT) als auch das Enable-Signal (EN-BOT) an- bzw. vorliegt zu Beginn des Zeitraumes (D) angeschalten. Durch das Anschalten des BOT-Schalters wird dessen Enable-Signal (EN-BOT) wieder zurückgesetzt.

Analog verläuft das Anschalten des TOP-Schalters zu Beginn des Zeitraumes (F), da hier das durch das Ausschalten des BOT-Schalters erzeugte Enable-Signal (EN-TOP) als auch das Ansteuersignal (A-TOP) des Kontrollrechners vor- bzw. anliegt. Auch hier wird das Enable-Signale (EN-TOP) durch das Anschalten des TOP-Schalters zurückgesetzt.

Fig. 2 zeigt die Ansteuersignale sowie die daraus erzeugten Enable-Signale im fehlerbehafteten Betrieb. Als Fehler wird hier ein nicht konstant anliegendes Ansteuersignal (A-BOT) im Zeitraum (D) angenommen. Das hier dargestellte Ansteuersignal im Zeitraum (D) würde auf Grund der hohen Frequenz den BOT-Schalter durch hochfrequente Schaltvorgänge zerstören. Zu Beginn des Zeitraumes (D) liegt sowohl das Enable-Signal (EN-BOT), das durch das vorhergehende Abschalten des TOP-Schalters erzeugt wurde, vor als auch das Ansteuersignal (A-BOT) des Kontrollrechners an. Die Treiberschaltung schaltet somit den BOT-Schalter ein wie dies die korrigierte Kurve (K-BOT) darstellt, gleichzeitig wird das Enable-Signal (EN-BOT) zurückgesetzt. Nachdem der BOT-Schalter innerhalb des Zeitraumes (D) nach kurzer Zeit aufgrund eines fehlenden Ansteuersignals wieder ausgeschaltet wird, wird dieser bei erneut vorhandenem Ansteuersignal nicht wieder eingeschalten, da das entsprechende Enable-Signal (EN-BOT) aufgrund eines fehlenden Ausschaltens des TOP-Schalters nicht vorliegt.

Somit wird ein hochfrequentes Ein- und Ausschalten und damit die wahrscheinliche Zerstörung desjenigen Schalters, dessen Ansteuersignal störungsbehaftet ist wirksam vermieden.

Um dem Kontrollrechner über eine entsprechende Signalleitung einen Fehler mitteilen zu können, werden die beiden Signale (A-TOP) und (K-TOP) bzw. (A-BOT) und (K-BOT) verglichen. Eine unterschiedliche Signallänge signalisiert einen Fehler.

## Patentansprüche

1. Verfahren zur Erkennung und anschließender Behandlung eines Fehlers in der Datenübertragung zu einer Treiberschaltung für Leistungshalbleiterschalter, angeordnet in einer Halbbrückenschaltung oder einer daraus aufgebauten Schaltung, wobei für jeden Leistungshalbleiterschalter (TOP, BOT) ein eigenes Ansteuersignal (A-TOP, A-BOT) von einem Kontrollrechner zur Treiberschaltung übertragen wird aus jedem Ansteuersignal ein eigenes Enable-Signal (EN-TOP, EN-BOT) für den jeweils anderen Leistungshalbleiterschalter derart erzeugt wird, dass bei Beendigung des Ansteuersignals des Leistungshalbleiterschalters das Enable-Signal des jeweils anderen Leistungshalbleiterschalters gesetzt wird, und ein Leistungshalbleiterschalter nur dann durch die Treiberschaltung angesteuert wird, falls das entsprechende Ansteuersignal vom Kontrollrechner an der Treiberschaltung anliegt und das jeweils zugehörige, in der Treiberschaltung gebildete, Enable-Signal ebenfalls vorliegt.

2. Verfahren nach Anspruch 1, wobei
die Datenübertragung mittels Lichtsignalen in Lichtwellenleitern erfolgt.
